# EUROPEAN PATENT SPECIFICATION

(11) **EP 3 605 719 B1**
(45) Date of publication and mention of the grant of the patent: **30.12.2020**
(21) Application number: 18874537.6
(22) Date of filing: 06.11.2018
(51) Int. Cl.: H01M 10/48, H01M 10/42, H01M 2/10

(54) **BATTERY MODULE**
BATTERIEMODUL
MODULE DE BATTERIE

(30) Priority: 06.11.2017 KR 20170146776
(43) Date of publication of application: 05.02.2020
(73) Proprietor: LG Chem, Ltd., Seoul 07336 (KR)
(72) Inventor: YOON, Han Ki, Daejeon 34122 (KR)
(74) Representative: Plasseraud IP
(86) International application number: PCT/KR2018/013339
(87) International publication number: WO 2019/088789

(56) References cited:
- WO-A1-2017/006763
- DE-A1-102016 203 422
- KR-A- 20150 089 483
- KR-A- 20160 061 638
- KR-A- 20160 061 721
- KR-A- 20160 076 864
- US-A1- 2015 214 583
- US-A1- 2017 250 395

## Description

Recently, as technology development of and demand for mobile devices grow, demand for a rechargeable battery as an energy source has been rapidly increased. Accordingly, various researches and studies with respect to a rechargeable battery that can fulfill various needs have been carried out.

The rechargeable battery can be classified into a cylindrical rechargeable battery, a prismatic rechargeable battery, and a pouch-type rechargeable battery depending on the shape, and in terms of materials, there is a high demand for a lithium rechargeable battery as a lithium ion battery and a lithium ion polymer battery having high energy density and high discharge voltage as well as and output stability.

The rechargeable battery continuously repeats charging and discharging, and through such a process, a large amount of heat is generated and an output voltage state of the battery may be changed. A temperature increase and an output voltage change due to the heat generation cause malfunctioning of an element that uses the corresponding battery, deteriorates operation efficiency, and shortens a life-span of the battery.

In addition, since a battery pack includes a battery module structure in which a plurality of battery cells are embedded in a pack case, a problem may occur in safety and operation efficiency of the battery pack when over-voltage, over-current, and over-heating occur in some of the battery cells. Accordingly, a temperature sensor and the like is connected to the battery cells to control the battery cells while determining an operation state of the battery cell in real time or at regular intervals. However, a temperature measurement error may occur depending on the degree of contact of the temperature sensor with the battery cell.

For example, US patent 2015/0214583 discloses a battery module comprising a temperature sensor.

### [DISCLOSURE]

### [Technical Problem]

Exemplary embodiments of the present invention have been made in an effort to provide a battery module in which a force is applied toward a direction of a battery cell and thus a temperature sensor stably contacts the battery cell, thereby increasing accuracy in measurement of a battery cell temperature.

However, the problems to be solved by the embodiments of the present invention are not limited to the above-mentioned problems, but can be variously extended within the scope of the technical idea included in the present invention.

### [Technical Solution]

A battery module including a temperature sensor according to an exemplary embodiment of the present invention includes: a flexible printed circuit board where the temperature sensor is provided; a battery cell that overlaps a portion of the flexible printed circuit board, in which the temperature sensor is provided; and an upper plate that is disposed above the flexible printed circuit board, wherein the upper plate is partially cut and thus an elastic member is formed, and the elastic member presses the portion of the flexible printed circuit board in which the temperature sensor is provided and thus the battery cell and the flexible printed circuit board contact each other.

The battery module includes a compression pad that is disposed between a compression pad that is disposed between the upper plate and the flexible printed circuit board.

The battery module may further include: a first adhesive layer that is disposed between the compression pad and the upper plate; and a second adhesive layer that is disposed between the compression pad and the flexible printed circuit board.

The first adhesive layer and the second adhesive may be respectively provided as a double-sided adhesive tape.

A force is applied in a direction toward the battery cell by an elastic force of the elastic member such that the temperature sensor contacts the battery cell.

The temperature sensor may be a thermistor.

A gap between the elastic member and the battery may be smaller than a gap between the upper plate and the battery cell.

The battery cell may be provided in plural and a lamination direction of the plurality of battery cells may be parallel with a top surface of the upper plate, and the flexible printed circuit board may contact a side surface of the battery cell.

The elastic member may be formed in plural in the upper plate, and each elastic member may contact a different battery cell.

The compression pad may be formed of polyurethane foam.

### [Advantageous Effects]

According to the exemplary embodiments, a battery module in which the temperature sensor is stably attached to a battery cell by applying a force toward the battery cell using an elastic member formed on the upper plate can be provided, thereby improving accuracy of temperature measurement of the battery cell.

### [Description of the Drawings]

FIG. 1 is a schematic perspective view of a battery module according to an exemplary embodiment of the present invention.
FIG. 2 is a partially enlarged view of a portion "A" in FIG. 1.
FIG. 3 is a partial schematic view of the inside of the portion "A" of FIG. 1.
FIG. 4 is a cross-sectional view of FIG. 2, taken along the line I-I'.
FIG. 5 is a perspective view of an array of a plurality of battery cells by exposing the upper plate in FIG. 1.

### [Mode for Invention]

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention.

The drawings and description are to be regarded as illustrative in nature and not restrictive. Like reference numerals designate like elements throughout the specification.

Further, in the drawings, size and thickness of each element are arbitrarily represented for better understanding and ease of description, but the present invention is not limited thereto. In the drawings, the thickness of layers, films, panels, regions, etc., are exaggerated for clarity. In addition, for convenience of description and better understanding, the thickness of some of layers and regions is exaggerated in the drawings.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means positioned on or below the object portion, and does not necessarily mean positioned on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, in this specification, the phrase "on a plane" means viewing a target portion from the top, and the phrase "on a cross-section" means viewing a cross-section formed by vertically cutting a target portion from the side.

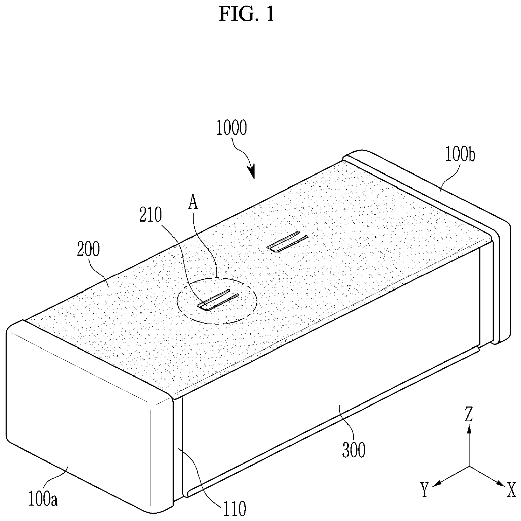

FIG. 1 is a schematic perspective view of a battery module according to an exemplary embodiment of the present invention.

Referring to FIG. 1, a battery module 1000 according to an exemplary embodiment of the present invention includes a battery cell laminate 110, first and second end plates 100a and 100b, an upper plate 200, and a lower plate (not shown). The battery cell laminate 110 may be covered by a cell cover 300.

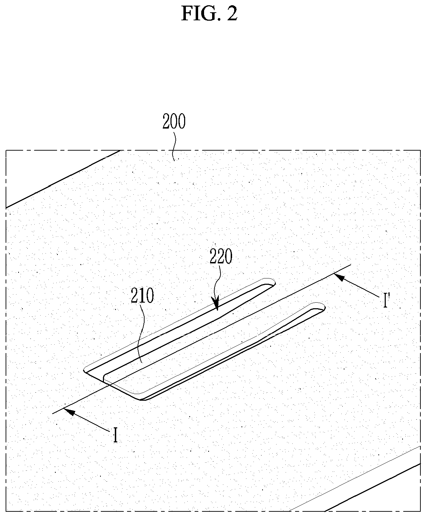

In the present exemplary embodiment, the upper plate 200 is partially cut such that an elastic member 210 may be formed. Such an elastic member 210 may be provided in plural, and the elastic member 210 may be bent toward the battery cell laminate 110. The elastic member 210 according to the present exemplary embodiment will now be described in detail with reference to FIG. 2 to FIG. 4.

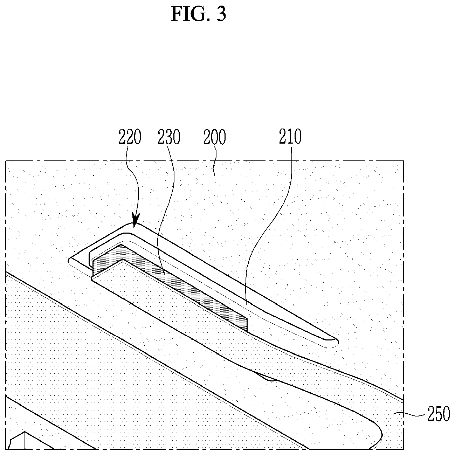

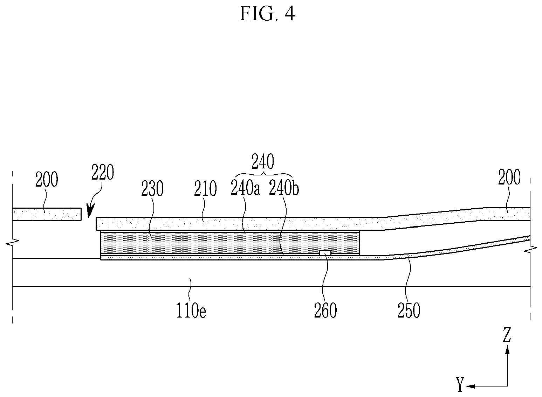

FIG. 2 is a partially enlarged view of a portion A of FIG. 1. FIG. 3 schematically shows the inside of the portion A of FIG. 1. FIG. 4 is a cross-sectional view of FIG. 2, taken along the line I-I'.

Referring to FIG. 1 and FIG. 2, the elastic member 210 according to the present exemplary embodiment may be formed by partially cutting the upper plate 200. Specifically, a cutout 220 formed in the shape of "⊏" is formed in a part of the upper plate 200, and a portion of the upper plate 200 remaining in a portion surrounded by the cutout 220 becomes the elastic member 210. The cutout 220 may be formed in plural in the upper plate 200, and the elastic member 210 is formed in each of the plurality of cutouts 220, and accordingly the elastic member 210 may be provided in plural.

Referring to FIG. 3, a flexible printed circuit board 250 is disposed at a lower end of the elastic member 210. One end of the flexible printed circuit board 250 extends along a direction in which the elastic member 210 extends, and the elastic member 210 may mostly overlap the flexible printed circuit board 250 in an x-axis direction of FIG. 1.

In the present exemplary embodiment, a compression pad 230 is disposed between the elastic member 210 and one end of the flexible printed circuit board 250. The compression pad 230 may be formed of polyurethane foam. Since the compression pad 230 is additionally formed, durability of the elastic member 210 can be improved. In addition, even when a side surface portion of the battery cell, which will be described later, is not completely parallel with a top surface of the top plate 200, an area where the flexible printed circuit board 250 and the battery cell contact each other may be increased by a cushion effect of the compression pad 230. In other words, since the compression pad 230 according to the present embodiment formed of a polyurethane foam or the like has dimensional stability, it can be used on a non-flat surface, and the compression pad 230 increases a contact surface or contactability, and has durability, thereby assuring performance with respect to vibration and impact.

Referring to FIG. 4, a temperature sensor 260 is installed in the flexible printed circuit board 250 according to the present exemplary embodiment. A portion of the flexible printed circuit board 250, in which the temperature sensor 260 is installed, overlaps a battery cell 110e, which is one of battery cells included in the battery cell laminate 110 of FIG. 1 in the z-axis direction.

In the present exemplary embodiment, the elastic member 210 presses the portion of the flexible printed circuit board 250, in which the temperature sensor 260 is installed, such that the battery cell 110e and the flexible printed circuit board 250 contact each other. That is, the battery cell 110e and the flexible printed circuit board 250 directly contact each other without disposing any element between the battery cell 110e and the flexible printed circuit board 250, and thus the temperature sensor 260 can accurately measure heat and the like generated from the battery cell 110e.

Since the elastic member 210 pushes the battery cell 110e along the z-axis direction and thus a force is applied in a direction of the battery cell 110e by an elastic force of the elastic member 210, the temperature sensor 260 and the battery cell 1102 can be stably maintained in a contact state.

Additionally, an adhesive layer 240 may be formed in each of an upper surface and a lower surface of the compression pad 230. A first adhesive layer 240a may be disposed between the compression pad 230 and the elastic member 210, and a second adhesive layer 240b may be disposed between the compression pad 230 and the flexible printed circuit board 250. The first adhesive layer 240a and the second adhesive layer 240b may be provided as a double-sided adhesive tape. The flexible printed circuit board 250 can be combined to the elastic member 210 by using such a double-sided adhesive tape.

As shown in FIG. 4, in the present exemplary embodiment, a gap between the elastic member 210 and the battery cell 110e is smaller than a gap between the upper plate 200 and the battery cell 110e.

The temperature sensor 260 may be implemented by using a thermistor. The thermistor is a semiconductor with resistance that changes in response to a temperature, and may be formed by mixing and sintering an oxide such as copper, manganese, nickel, cobalt, chromium, iron, and the like. Such a thermistor is advantageous in that it is small in size and can measure a fast temperature change and a fine temperature change.

Temperature information measured by the temperature sensor 260 can be transmitted to other devices outside of the battery module. For example, when a temperature is measured by the temperature sensor 260, the measured temperature information is transmitted to a battery management system (BMS) outside of the battery module and thus may be used to control the battery module. For this, the battery module may include a cable for temperature measurement (not show) of which one end is connected to the temperature sensor 260. A connector may be provided at the other end of the cable, and the connector may be connected with an external device such as the BMS.

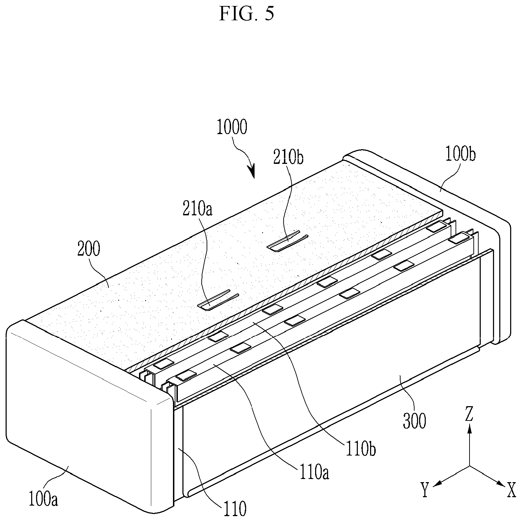

FIG. 5 is a perspective view of a plurality of battery cell arrays exposed by partially exposing the upper plate in FIG. 1.

Referring to FIG. 5, the battery cell laminate 110 of FIG. 1 includes a plurality of battery cells 110a and 110b, and a direction in which the plurality of battery cells 110a and 110b are arranged may be an X-direction that is parallel with the top surface of the upper plate 200. The battery cells 110a and 110b may each be formed in the shape of a rectangle having a length in a Y-axis direction and a width in a Z-axis direction.

As described above, two or more elastic members 210a and 210b are formed in the upper plate 200, and each of the two elastic members 210a and 210b may press the flexible printed circuit board that contacts a side surface of another battery cell.

While this invention has been described in connection with what is presently considered to be practical exemplary embodiments, it is to be understood that the invention is not limited to the disclosed embodiments.

### <Description of symbols>

- 1000:: battery module
- 210:: elastic member
- 220:: cutout
- 230:: compression pad
- 240:: adhesive layer
- 250:: flexible printed circuit board
- 260:: temperature sensor

## Claims

1. A battery module including a temperature sensor (260), comprising:
a flexible printed circuit board (250) where the temperature sensor (260) is provided;
a battery cell (110e) that overlaps a portion of the flexible printed circuit board (250), in which the temperature sensor (260) is provided;
an upper plate (200) that is disposed above the flexible printed circuit board (250); and
a compression pad (230) that is disposed between the upper plate (200) and the flexible printed circuit board (250),
wherein the upper plate (200) is partially cut and thus an elastic member (210) is formed, and the elastic member (210) presses the portion of the flexible printed circuit board (250) in which the temperature sensor (260) is provided and thus the battery cell (110e) and the flexible printed circuit board (250) contact each other; and
a force is applied in a direction toward the battery cell (110e) by an elastic force of the elastic member (210) such that the temperature sensor (260) contacts the battery cell (110e).

2. The battery module of claim 1, further comprising:
a first adhesive layer (240a) that is disposed between the compression pad (230) and the upper plate (200); and
a second adhesive layer (240b) that is disposed between the compression pad (230) and the flexible printed circuit board (250).

3. The battery module of claim 2, wherein the first adhesive layer and the second adhesive are respectively provided as a double-sided adhesive tape.

4. The battery module of claim 1, wherein the temperature sensor (260) is a therm istor.

5. The battery module of claim 1, wherein a gap between the elastic member (210) and the battery cell is smaller than a gap between the upper plate (200) and the battery cell.

6. The battery module of claim 1, wherein the battery cell is provided in plural and a lamination direction of the plurality of battery cells is parallel with a top surface of the upper plate (200), and the flexible printed circuit board (250) contacts a side surface of the battery cell (110e).

7. The battery module of claim 6, wherein the elastic member (210) is formed in plural in the upper plate (200), and each elastic member contacts a different battery cell (110e).

8. The battery module of claim 1, wherein the compression pad (230) is formed of polyurethane foam.

## Patentansprüche

1. Batteriemodul, umfassend einen Temperatursensor (260), umfassend:
eine flexible Leiterplatte (250), an welcher der Temperatursensor (260) bereitgestellt ist;
eine Batteriezelle (110e), welche einen Abschnitt der flexiblen Leiterplatte (250) überlappt, an welchem der Temperatursensor (260) bereitgestellt ist;
eine obere Platte (200), welche oberhalb der flexiblen Leiterplatte (250) angeordnet ist; und
ein Kompressionspolster (230), welches zwischen der oberen Platte (200) und der flexiblen Leiterplatte (250) angeordnet ist,
wobei die obere Platte (200) teilweise eingeschnitten ist und somit ein elastisches Element (210) gebildet ist und das elastische Element (210) gegen den Abschnitt der flexiblen Leiterplatte (250) drückt, an welchem der Temperatursensor (260) bereitgestellt ist, und somit die Batteriezelle (110e) und die flexible Leiterplatte (250) einander kontaktieren; und
durch eine elastische Kraft des elastischen Elements (210) eine Kraft in einer Richtung zu der Batteriezelle (110e) hin ausgeübt wird, so dass der Temperatursensor (260) die Batteriezelle (110e) kontaktiert.

2. Batteriemodul nach Anspruch 1, ferner umfassend:
eine erste adhäsive Schicht (240a), welche zwischen dem Kompressionspolster (230) und der oberen Platte (200) angeordnet ist; und
eine zweite adhäsive Schicht (240b), welche zwischen dem Kompressionspolster (230) und der flexiblen Leiterplatte (250) angeordnet ist.

3. Batteriemodul nach Anspruch 2, wobei die erste adhäsive Schicht und die zweite adhäsive Schicht jeweils als ein doppelseitiges adhäsives Band bereitgestellt sind.

4. Batteriemodul nach Anspruch 1, wobei der Temperatursensor (260) ein Thermistor ist.

5. Batteriemodul nach Anspruch 1, wobei ein Spalt zwischen dem elastischen Element (210) und der Batteriezelle kleiner als ein Spalt zwischen der oberen Platte (200) und der Batteriezelle ist.

6. Batteriemodul nach Anspruch 1, wobei die Batteriezelle in einer Mehrzahl bereitgestellt ist und eine Laminierungsrichtung der Mehrzahl von Batteriezellen parallel zu einer oberen Fläche der oberen Platte (200) ist und die flexible Leiterplatte (250) eine seitliche Fläche der Batteriezelle (110e) kontaktiert.

7. Batteriemodul nach Anspruch 6, wobei das elastische Element (210) in einer Mehrzahl in der oberen Platte (200) gebildet ist und jedes elastische Element eine andere Batteriezelle (110e) kontaktiert.

8. Batteriemodul nach Anspruch 1, wobei das Kompressionspolster (230) aus Polyurethanschaum gebildet ist.

## Revendications

1. Module de batterie comportant un capteur de température (260), comprenant :
une carte de circuit imprimé souple (250) où le capteur de température (260) est fourni ;
un élément de batterie (110e) qui chevauche une portion de la carte de circuit imprimé souple (250), dans laquelle le capteur de température (260) est fourni ;
une plaque supérieure (200) qui est disposée au-dessus de la carte de circuit imprimé souple (250) ; et
un tampon de compression (230) qui est disposé entre la plaque supérieure (200) et la carte de circuit imprimé souple (250),
dans lequel la plaque supérieure (200) est découpée partiellement et ainsi un organe élastique (210) est formé, et l'organe élastique (210) appuie sur la portion de la carte de circuit imprimé souple (250) dans laquelle le capteur de température (260) est fourni et ainsi l'élément de batterie (110e) et la carte de circuit imprimé souple (250) entrent en contact l'un avec l'autre ; et
une force est appliquée dans une direction vers l'élément de batterie (110e) par une force élastique de l'organe élastique (210) de sorte que le capteur de température (260) entre en contact avec l'élément de batterie (110e).

2. Module de batterie selon la revendication 1, comprenant en outre :
une première couche adhésive (240a) qui est disposée entre le tampon de compression (230) et la plaque supérieure (200) ; et
une seconde couche adhésive (240b) qui est disposée entre le tampon de compression (230) et la carte de circuit imprimé souple (250).

3. Module de batterie selon la revendication 2, dans lequel la première couche adhésive et la seconde couche adhésive sont fournies respectivement sous la forme d'un ruban adhésif double face.

4. Module de batterie selon la revendication 1, dans lequel le capteur de température (260) est un thermistor.

5. Module de batterie selon la revendication 1, dans lequel un écartement entre l'organe élastique (210) et l'élément de batterie est plus petit qu'un écartement entre la plaque supérieure (200) et l'élément de batterie.

6. Module de batterie selon la revendication 1, dans lequel l'élément de batterie est fourni en plusieurs exemplaires et une direction de stratification de la pluralité d'éléments de batterie est parallèle à une surface de dessus de la plaque supérieure (200), et la carte de circuit imprimé souple (250) entre en contact avec une surface de côté de l'élément de batterie (110e).

7. Module de batterie selon la revendication 6, dans lequel l'organe élastique (210) est formé en plusieurs exemplaires dans la plaque supérieure (200), et chaque organe élastique entre en contact avec un élément de batterie (110e) différent.

8. Module de batterie selon la revendication 1, dans lequel le tampon de compression (230) est formé de mousse polyuréthane.
